# EUROPEAN PATENT SPECIFICATION

(11) **EP 0 425 033 B1**
(45) Date of publication and mention of the grant of the patent: **03.01.1996**
(21) Application number: 90202799.4
(22) Date of filing: 19.10.1990
(51) Int. Cl.: G11B 20/10

(54) **Device for reading digital information recorded on an information carrier**
Anordnung zum Lesen einer auf einem Informationsträger aufgezeichneten digitalen Information
Dispositif de lecture d'information numérique enregistré sur un support d'information

(30) Priority: 23.10.1989 NL 8902613
(43) Date of publication of application: 02.05.1991
(73) Proprietor: Philips Electronics N.V., NL-5621 BA Eindhoven (NL)
(72) Inventor: Naus, Peter Johannes Anna, NL-5656 AA Eindhoven (NL)
(74) Representative: Faessen, Louis Marie Hubertus

(56) References cited:
- EP-A- 0 218 870
- EP-A- 0 228 245
- EP-A- 0 406 021
- US-A- 3 879 674
- PATENT ABSTRACTS OF JAPAN vol. 9, no. 115 (E-315)(1838) 18 May 1985,& JP-A-60 4322 (FUJITSU K.K.) 10 January 1985,
- PATENT ABSTRACTS OF JAPAN vol. 8, no. 74 (E-236)(1511) 06 April 1984,& JP-A-58 221510 (SONY K.K.) 23 December 1983,
- PATENT ABSTRACTS OF JAPAN vol. 9, no. 234 (E-344)(1957) 20 September 1985,& JP- A-60 87511 (ROOMU K.K.) 17 May 1985,
- PATENT ABSTRACTS OF JAPAN vol. 7, no. 292 (E-219)(1437) 27 December 1983,& JP- A-58 168313 (FUJITSU) 04 October 1983,
- PATENT ABSTRACTS OF JAPAN vol. 3, no. 58 (E-111) 18 May 1979,& JP-A-54 037449 (NEC CORPORATION) 19 March 1979,

## Description

The invention relates to a device for reading digital information recorded on an information carrier, the device comprising a signal processor for deriving a digital signal from the digital information being read and a controllable digital amplifier.

Such a device is known from the article "Aiwa offers high-end functions in the popular price range" in the "Journal of the Electronics Industry" of February 1989, page 43. The device described in the article is a CD player constructed to read information carriers in the form of Compact Discs (CDs). The digital information recorded on such CDs comprises a digital audio signal, which is derived from this information after reading. By means of digital-to-analog converter the prior-art CD player converts the digital audio signal thus derived into an analog output signal. A customary parameter used to indicate the quality of the analog output signal is the signal-to-noise ratio, which is related to the dynamic range, which is the ratio between the maximum signal level and the noise level of said output signal.

Further JP-A-58-221510 which is reflected in the preamble of claim 1 discloses a digital audio signal processor for preventing clipping while transmitting an audio signal, comprising a delay, a peak detector arranged before the delay and a digital gain control circuit, arranged after the delay. If a peak exceeds a prescribed level, the gain is reduced before transmission.

It is an object of the invention to provide a device for reading digital information recorded on an information carrier, yielding an improved signal-to-noise ratio of the analog output signal.

According to the invention a device for reading digital information recorded on an information carrier is characterized by said signal processor comprising means for reading a peak code recorded on the information carrier and by means for generating a peak code related control signal for controlling the gain of the digital amplifier, said amplifier being constructed to perform further signal processing.

The peak code is a measure of the peak level in the digital signal. The control signal generated by the means enables the gain of the digital amplifier to be controlled in such a manner that the maximum signal value of the amplified digital signal corresponds substantially to the maximum signal value which can be handled by the digital-to-analog converter. Thus, the digital-to-analog converter coupled to the digital amplifier is driven to a maximum extent regardless of the magnitude of the peak signal, so that additional noise subsequently added by this converter has a minimal influence on the signal-to-noise ratio of the analog output signal. Investigations in this field show that in the case of CDs generally a limited part of the available dynamic range of the recorded digital audio signal is used, almost two bits of this sixteen-bit standard audio signal not being utilized. Therefore, when the invention is applied to CDs this usually yields a substantial improvement of said signal-to-noise ratio.

An information carrier for use in conjunction with such a device may contain the digital peak code in the digital information recorded on the information carrier. Insertion of the peak code in the information on a digital information carrier ensures that the peak signal can be obtained without prior resort to a memory of the peak detector or without regeneration of said signal. Therefore, the use of the peak code is simpler and saves both time and hardware.

It is to be noted that an amplifier whose gain is related to a peak level of a signal to be amplified is known from British Patent Specification GB 1,332,219, but this Patent Specification describes the gain control of an analog amplifier for the purpose of an optimum reproduction of electrocardiographic signals on a display screen. In contrast, the device in accordance with the invention concerns a digital system for improving the signal-to-noise ratio of an analog output signal of a digital-to-analog converter.

Further it is to be noted, that EP-A-0 406 021, which is to be considered as prior art under Art.54(3) EPC, discloses a disk reproducing device comprising means to retrieve a peak level code from the disk and a level control circuit for adjusting the reproducing level of the music accordingly. The level control circuit is not constructed for further signal processing.

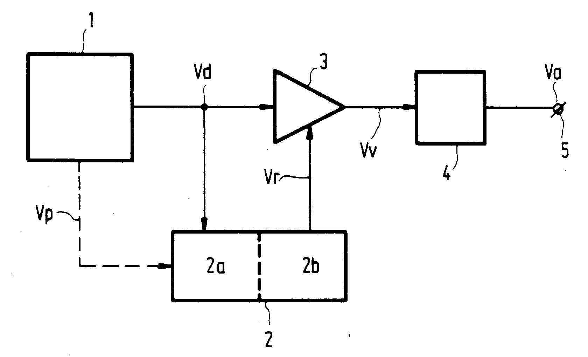

The invention will now be described in more detail with reference to the accompanying Figure, which shows an embodiment of a device in accordance with the invention for reading digital information recorded on an information carrier.

The device shown herein comprises a signal processor 1, a peak detector 2, a digital amplifier 3, and a digital-to-analog converter 4 having an output terminal 5. The signal processor 1, which is of a type, for example, as commonly used in CD players or DAT recorders, produces a digital signal Vd, which is derived from digital information recorded on an information carrier. This signal Vd is applied both to the peak detector 2 and to the digital amplifier 3. In the present embodiment the peak detector 2 comprises a detection and storage unit 2a for supplying a peak signal which is a measure of the peak level in the digital signal Vd and a control unit 2b for controlling the gain of the digital amplifier 3. For this purpose the control unit 2b employs a control signal Vr which is inversely proportional to the peak signal. The control signal Vr controls said gain via a control input of the amplifier 3 in such a manner that the peak level of the digital signal Vd is amplified to obtain an amplified digital signal Vv having a signal value corresponding to the maximum value which can be handled by the digital-to-analog converter 4. During conversion of the amplified digital signal Vv into an analog output signal Va available on the output terminal 5 the converter 4 adds analog noise to said output signal Va. Since the gain of the digital amplifier 3 is controlled by the peak detector 2 the influence of the analog noise on the signal-to-noise ratio of the output signal Va is now minimized. Owing to the use of the invention the digital-to-analog converter 4 is capable of supplying an output signal of greatly improved signal quality. With respect to the detection and storage unit 2a the peak detector 2 described above may be constructed, for example, as set forth in said article in the "Journal of the Electronics Industry". Storage is then effected in a memory which allows the peak signals for a plurality of information carriers to be retained and retrieved. With respect to the detection the device in accordance with the invention can be simplified by adapting the signal processor 1 in such a manner that it is also capable of deriving a peak code Vp which is recorded on the record carrier and which is a measure of the peak level of the digital signal Vd. For example, this peak code Vp may be inserted in the lead-in information of an information carrier and after it has been recovered it may be applied directly to the peak detector 2. In this case the peak detector 2 need not detect the peak level in the digital signal Vd and can employ the peak code Vp directly as a measure of the peak signal. Consequently, the control unit 2b in the device in accordance with the invention can generate the control signal Vr more rapidly.

The invention is not limited to the embodiments disclosed herein.

For example, the peak detector may be constructed in various manners, depending on inter alia the functions to be performed by the detector. The digital amplifier is constructed to perform further signal-processing functions such as equalizing and filtering. It is also possible to store a plurality of peak signals for a single information carrier, so that for example every music track of a CD can be treated separately. Similarly, a plurality of peak codes may be recorded on an information carrier.

## Claims

1. A device for reading digital information recorded on an information carrier, the device comprising a signal processor (1) for deriving a digital signal (Vd) from the information being read and a controllable digital amplifier (3),characterized by said signal processor comprising means for reading a peak code (Vp) recorded on the information carrier and by means (2) for generating a peak code (Vp) related control signal (Vr) for controlling the gain of the digital amplifier, said amplifier being constructed to perform further signal processing.

2. A device as claimed in claim 1, said means (2) comprising a peak detector supplying a peak code, which is a measure of a peak level in the digital signal (Vd).

3. A device as claimed in Claim 2, comprising a memory, which allows the peak codes for a plurality of information carriers to be retained and retrieved.

4. A device as claimed in claim 1, 2 or 3, characterized in that the device further comprises a digital-to-analog converter (4) for converting the processed digital signal (Vv) into an analog output signal (Va).

## Patentansprüche

1. Einrichtung zum Auslesen von auf einem Informationsträger aufgezeichneter digitaler Information, wobei die Einrichtung einen Signalprozessor (1) zum Ableiten eines digitalen Signals (Vd) aus der gelesenen Information und einen steuerbaren digitalen Verstärker (3) umfaßt, dadurch gekennzeichnet, daß der genannte Signalprozessor Mittel zum Lesen eines auf dem Informationsträger aufgezeichneten Peak-Codes (Vp) umfaßt sowie Mittel (2) zum Generieren eines mit dem Peak-Code (Vp) zusammenhängenden Steuersignals (Vr) zum Steuern der Verstärkung des digitalen Verstärkers, wobei der Verstärker zur Ausführung weiterer Signalverarbeitung eingerichtet ist.

2. Einrichtung nach Anspruch 1, wobei die genannten Mittel (2) einen Peak-Detektor umfassen, der einen Peak-Code liefert, der ein Maß für einen Peak-Pegel in dem digitalen Signal (Vd) ist.

3. Einrichtung nach Anspruch 2, mit einem Speicher, der es ermöglicht, die Peak-Codes für eine Vielzahl von Informationsträgern festzuhalten und zurückzugewinnen.

4. Einrichtung nach Anspruch 1, 2 oder 3, dadurch gekennzeichnet, daß die Einrichtung weiterhin einen Digital-Analog-Umsetzer (4) zum Umsetzen des verarbeiteten digitalen Signals (Vv) in ein analoges Ausgangssignal (Va) umfaßt.

## Revendications

1. Dispositif de lecture d'information numérique enregistrée sur un support d'information, le dispositif comprenant un processeur de signaux (1) destiné à extraire un signal numérique (Vd) de l'information lue, et un amplificateur numérique (3) contrôlable, caractérisé en ce que ledit processeur de signaux comprend des moyens de lecture d'un code de crêtes (Vp) enregistré sur le support d'information et des moyens (2) sont prévus pour produire un signal de commande (Vr) lié au code de crêtes (Vp) afin de commander le gain de l'amplificateur numérique, ledit amplificateur étant construit pour exécuter un traitement supplémentaire des signaux.

2. Dispositif suivant la revendication 1, lesdits moyens (2) comprenant un détecteur de crêtes fournissant un code de crêtes, qui est une mesure d'un niveau maximal dans le signal numérique (Vd).

3. Dispositif suivant la revendication 2, comprenant une mémoire qui permet aux codes de crêtes pour une pluralité de supports d'information d'être conservés et récupérés.

4. Dispositif suivant la revendication 1, 2 ou 3, caractérisé en ce que le dispositif comprend en plus un convertisseur numérique/analogique (4) pour convertir le signal numérique traité (Vv) en un signal de sortie analogique (Va).
